(19) Europäisches Patentamt
European Patent Office
Office européen des brevets

(11) **EP 2 945 258 B1**

(12) **EUROPÄISCHE PATENTSCHRIFT**

(45) Veröffentlichungstag und Bekanntmachung des Hinweises auf die Patenterteilung:
**13.09.2017 Patentblatt 2017/37**

(51) Int Cl.:
***H02J 7/14*** *(2006.01)*

(21) Anmeldenummer: **15165576.8**

(22) Anmeldetag: **29.04.2015**

(54) **VERFAHREN ZUM MANAGEMENT DER ELEKTRISCHEN STROMVERSORGUNG IN EINEM KRAFTFAHRZEUG**

METHOD FOR THE MANAGEMENT OF THE ELECTRICAL CURRENT SUPPLY IN A MOTOR VEHICLE

PROCÉDÉ DE GESTION DE L'ALIMENTATION DE COURANT ÉLECTRIQUE DANS UN VÉHICULE AUTOMOBILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.05.2014 DE 102014209252**

(43) Veröffentlichungstag der Anmeldung:
**18.11.2015 Patentblatt 2015/47**

(73) Patentinhaber: **Ford Global Technologies, LLC Dearborn, MI 48126 (US)**

(72) Erfinder: **Eifert, Mark**
**60594 Frankfurt (DE)**

(74) Vertreter: **Dörfler, Thomas**
**Ford-Werke GmbH**
**Abt. NH/364**
**Henry-Ford-Strasse 1**
**50735 Köln (DE)**

(56) Entgegenhaltungen:
DE-A1- 10 150 374     DE-A1-102005 046 342
DE-T2- 60 033 861     US-A- 5 820 172

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Management der elektrischen Stromversorgung in einem Kraftfahrzeug mit Verbrennungsmotor sowie eine zur Durchführung des Verfahrens eingerichtete Vorrichtung.

Ein Verfahren und eine Vorrichtung mit den Merkmalen der Oberbegriffe der unabhängigen Patentansprüche sind in der DE 10 2005 046 342 A1 offenbart.

Die DE 10 2004 023 621 A1 offenbart ein Verfahren und Vorrichtung zur Energieinhaltsbestimmung eines Energiespeichers. Beschrieben wird ein Konzept zur Bestimmung des Ladezustands einer Batterie in einem Fahrzeug, aber keine Strategie zum Korrigieren eines niedrigen Ladezustands oder zur Verbesserung des Wirkungsgrades des elektrischen Systems oder Antriebs. Der Ladezustand wird kontinuierlich abgeschätzt und als präziser numerischer Wert ausgegeben. Die Abschätzung des Ladezustands kann durch eine galvanische Abkopplung der Batterie von der elektrischen Leistungsquelle korrigiert werden. Die Korrektur kann periodisch angesetzt werden, oder sie kann sporadisch eingeplant werden, wenn eine günstige Fahrstrecke dafür vorliegt. Die Korrektur wird durch Messung der Leerlaufspannung der Batterie durchgeführt. Der Ladezustand ist eine Funktion der Leerlaufspannung, wenn die Batterie lang genug unbelastet ist. Zwischen den Korrekturen wird die Bestimmung des Ladezustands durch Integration des Batteriestroms durchgeführt. Dabei wird der Ladezustand nach einer Korrektur (Messung der Leerlaufspannung und Bestimmung eines Ladezustands) als Anfangswert der Integration verwendet.

Die US 6 646 419 B1 offenbart ein Verfahren zur Bestimmung des Ladezustands einer Blei-Säure-Batterie in einem Fahrzeug. Auch hier wird der Ladezustand kontinuierlich abgeschätzt und als ein präziser numerischer Wert ausgegeben. Auch hier wird der Ladezustand durch Integration des Lade- bzw. Entladestroms bestimmt. Dabei wird der sekundäre Batteriestrom, der in die Gasbildung und die Aufheizung der Batterie eingeht, aber nicht gespeichert wird, berechnet. Die Differenz zwischen gesamtem Batteriestrom und sekundärem Batteriestrom ergibt den Lade- bzw. Entladestrom, der bei der Bestimmung des Ladezustands integriert wird. Auch hier wird der Anfangswert des Ladezustands aus der Leerlaufspannung der Batterie nach einer Phase mit null oder geringem Batteriestrom bestimmt. Wenn das Fahrzeug länger Zeit geparkt war, wird ein neuer Wert für den Anfangswert des Ladezustands aus der Leerlaufspannung berechnet. Es wird auch beschrieben, dass der Anfangswert des Ladezustands beim Fahren korrigiert werden kann. Dabei wird die Leerlaufspannung der Batterie nach einer langen Phase mit null Batteriestrom mit dem gemessenen Batteriestrom abgeschätzt. Es wird nicht näher beschrieben, wann die geschätzte Klemmenspannung verwendet wird, um den Anfangs-Ladezustand zu korrigieren.

Die US 8 159 188 B2 offenbart ein Verfahren zur Regelung des Ladezustands einer Lithium-Ionen-Fahrzeugbatterie, so dass immer ein minimaler Entladestromwert erreichbar ist. Das Verfahren sorgt bei alternden Batterien dafür, dass sie immer genügend Entladestrom liefern können. Dabei wird der Ladezustand der Batterie zwischen einem minimalen und einem maximalen Ladezustand gehalten. Wird festgestellt, dass ein geforderter Entladestrom nicht erreicht werden kann, wird der minimale Ladezustand in einem Teil-Ladebetrieb erhöht. Die Erhöhung ist eine Funktion der Differenz zwischen gefordertem und geliefertem Strom, der Batterie-Temperatur, des Ladezustands und anderer Batterie-Zustände.

Die US 8 638 070 B2 offenbart ein Verfahren zum adaptiven Laden einer Batterie auf einen Sollwert. Der Ladezustand wird abgeschätzt und als ein präziser numerischer Wert ausgegeben. Die Abschätzung erfolgt durch eine aktive Steuerung der Klemmenspannung der Batterie durch eine Folge von Lade- und Entladepulsen. Die Pulse haben vordefinierte Stromprofile, und die Spannungsantwort der Pulse werden verwendet, um den Ladezustand abzuschätzen. Die Lade bzw. Entladepulse müssen Spannungsantworten innerhalb enger Toleranzen erzeugen. Ihre genaue Form wird dauernd adaptiert, damit die Antworten innerhalb der Toleranzen bleiben. Die Pulse werden immer periodisch bzw. unabhängig vom Betriebszustand des gesamten Systems durchgeführt. Weil die Spannungsantwort auf einen vorbestimmten Strom verwendet wird, um den Ladezustand abzuschätzen, wird eine Beziehung zwischen den äquivalenten Kapazitäten der Batterie und dem Ladezustand verwendet, um die Abschätzung durchzuführen. Dieses Verfahren wurde für Lithium-Ionen-Batterien entwickelt und soll auch für andere Typen wie Ni-MH benutzt werden können. Es gibt aber keinen Hinweis auf Blei-Säure-Batterien.

D.h., es ist bekannt, einen niedrigen Ladezustand zu detektieren und zu korrigieren oder die elektrische Robustheit veralteter Batterien durch einen höheren minimalen Ladezustand zu verbessern.

Der Erfindung liegt die Aufgabe zu Grunde, ein Verfahren zum Management der elektrischen Stromversorgung in einem Kraftfahrzeug mit Verbrennungsmotor bereitzustellen, das es mit minimalem Aufwand ermöglicht, nicht nur einen niedrigen Batterieladezustand zu detektieren und zu korrigieren und damit elektrische Robustheit zu erzielen, sondern auch, den Kraftstoffverbrauch zu verbessern und $CO_2$-Emissionen zu verringern.

Diese Aufgabe wird durch ein Verfahren und eine Vorrichtung gemäß den unabhängigen Patentansprüchen gelöst.

Vorteilhafte Weiterbildungen der Erfindung sind in den abhängigen Patentansprüchen angegeben.

Die Erfindung liefert eine Betriebsstrategie für die Lichtmaschine eines Kraftfahrzeugs, die den Kraftstoffverbrauch minimieren und elektrische Robustheit gewährleisten kann. Elektrische Robustheit wird durch Implementation eines Algorithmus für diskrete Erkennung eines niedrigen Ladezustands gewährleistet.

Im Rahmen der Erfindung wird der Ladezustand periodisch oder fahrtabhängig mit einem vorgegebenen Wert verglichen, um eine diskrete und insbesondere binäre Ausgangsgröße in Form eines Bits oder Merkers zu erhalten, die angibt, ob der Ladezustand unter einer vorgegebenen Schwelle liegt. Falls die elektrische Stromquelle zwischen den Vergleichen nicht gesättigt wird, wird angenommen, dass der Ladezustand zwischen den Prüfzeitpunkten nicht nachlässt. In diesem Fall wird der Zustand des Bits oder Merkers nicht geändert. Das erfindungsgemäße Verfahren gibt also keinen numerischen Wert für den Ladezustand aus, und der Energieinhalt der Batterie wird auch nicht direkt bestimmt bzw. abgeschätzt.

In einer bevorzugten Ausführungsform der Erfindung erfolgt ein Vergleich zwischen dem Ladezustand und einem vorgegebenen Wert durch eine periodische oder sporadische Absenkung der Klemmenspannung der Batterie. Dabei wird der Batteriestrom über ein Zeitfenster direkt oder indirekt bestimmt, um festzustellen, ob der Ladezustand größer oder kleiner ist als ein Wert, der eine Funktion der abgesenkten Spannung ist.

Das erfindungsgemäße Verfahren ermöglicht eine einfache Charakterisierung eines niedrigen Ladezustands und zugleich eine Verbesserung des Wirkungsgrades der elektrischen Stromversorgung und damit des gesamten Antriebs des Fahrzeugs.

Wird ein niedriger Ladezustand erkannt, wird ein entsprechender Merker gesetzt und es wird ein Laden der Batterie unter Verwendung einer relativ hohen Spannung über einen vorbestimmten Zeitraum durchgeführt. Die relativ hohe Spannung und der vorbestimmte Zeitraum sind eine Ausgleichsladespannung und eine Ausgleichsladezeitspanne, die erforderlich sind, um alle Zellen der Batterie gleichmäßig auf 100% ihrer Kapazität zu laden. Nach Ablauf der Ausgleichsladezeitspanne wird wieder der hinsichtlich des Kraftstoffverbrauchs günstigste Ladebetrieb durchgeführt.

Wie oben erwähnt, erfolgen Vergleiche zwischen dem Ladezustand und einem vorgegebenen Wert durch eine periodische oder sporadische Absenkung der Klemmenspannung der Batterie. Falls die Vergleiche sporadisch durchgeführt werden, werden sie abhängig von den Fahrbedingungen erzeugt. Besonders zweckmäßig ist es, sie nach einer Phase eines regenerativen Bremsens stattfinden zu lassen, wenn sich der Motor im Leerlauf befindet. Die Spannungsänderung kann sprunghaft oder mit einem Zeit-Gradienten geschehen. Während der Absenkung wird der Batteriestrom oder der Strom der elektrischen Stromquelle (der Lichtmaschine einschließlich Wechselrichter) mit Null verglichen. Falls der Strom der elektrischen Stromquelle immer Null ist oder als Entladung erkannt wird, wird der Ladezustand als über der vorgegebenen Schwelle identifiziert. Die Stromantwort der Batterie bzw. der elektrischen Stromquelle während periodischer oder sporadischer Entladungen entscheidet, ob der Ladezustand über oder unter der vorgegebenen Schwelle ist. Diese Strategie ist insbesondere für Blei-Säure-Batterien geeignet. Da Lithium-Ionen-Batterien ähnliche Äquivalenzschaltungsmodelle besitzen, kann die Strategie jedoch möglicherweise auch für diesen Typ von Batterie verwendet werden.

Die durch die Erfindung erzielte Reduzierung des Kraftstoffverbrauchs und der $CO_2$-Emissionen sind teilweise durch den Verzicht der Erzeugung elektrischer Leistung in Betriebsphasen mit einem niedrigen Wirkungsgrad bei der Leistungsumwandlung. In diesen Betriebsphasen wird die Lichtmaschine deaktiviert, und die Batterie entlädt sich. Das Entladungsvermögen der Batterie trägt zu den Vorteilen bei und verschlechtert sich in der Regel langsamer als der Alterungsvorgang der Batterie.

Es folgt eine Beschreibung von Ausführungsbeispielen anhand der Zeichnungen. Darin zeigen:

Fig. 1    einen Überblick über eine Lichtmaschinen-Steuerarchitektur mit einem Batteriemanagementsystem;

Fig. 2    die Abhängigkeit der Spannungseinstellungspunkte von der Temperatur für Betrieb des Antriebsstrangs bei unterschiedlichen Wirkungsgraden;

Fig. 3    die Auswahl des Spannungseinstellungspunkts für Betriebsarten mit hohem und niedrigem Wirkungsgrad;

Fig. 4    die Auswahl des Spannungseinstellungspunkts für Betriebsarten mit hohem und niedrigem Wirkungsgrad sowie für nicht gefeuerte Verzögerungen;

Fig. 5    die Ermittlung der Betriebsart nach Wirkungsgrad im Falle eines durch einen Ottomotor angetriebenen Antriebsstrangs;

Fig. 6    die Batterieklemmenspannung und den Batteriestrom während einer Überwachungszeitspanne für eine Batterie mit einem Ladezustand oberhalb und unterhalb des kalibrierten Schwellenwertes;

Fig. 7    das Management des Merkers LowSOCFlag bei der hierin beschriebenen minimalen Stromversorgungs-Managementstrategie unter Verwendung eines Batterieüberwachungssensors; und

Fig. 8     ein Beispiel für eine vollständige minimale Stromversorgungs-Managementstrategie.

Die hierin beschriebene minimale Stromversorgungs-Managementstrategie für das Management der elektrischen Stromversorgung in einem Kraftfahrzeug mit Verbrennungsmotor und regenerativem Bremssystem hat zwei Teile, die alternativ angewendet werden: eine Strategie, die den Spannungseinstellungspunkt der Lichtmaschine für den an Bord benötigten Strom im Hinblick darauf festsetzt, den Energieumwandlungswirkungsgrad des Antriebsstrangs und den Kraftstoffverbrauch zu verbessern, und eine Strategie, die den Batterieladezustand überwacht und ein Laden auf einem Einstellungspunkt mit hoher Spannung durchführt, falls der Batterieladezustand als niedrig erkannt wird.

Die hierin beschriebene Stromversorgungs-Managementstrategie wird als "minimal" bezeichnet, weil sie mit minimalem Aufwand durchgeführt werden kann, stets einen mindestens minimalen Ladezustand gewährleistet und außerdem dazu beiträgt, den Kraftstoffverbrauch zu minimieren.

Der Begriff Lichtmaschine umfasst hier nicht nur einen als Generator betriebenen Elektromotor, sondern auch den Wechselrichter, der daraus eine Gleichspannung erzeugt, und der ansteuerbar ist, eine gewünschte Ausgangsspannung zu liefern, so dass die Ausgangsspannung der Lichtmaschine in gewissen Grenzen einstellbar ist.

Derjenige Teil der Gesamtstrategie, der den Batterieladezustand überwacht und einen niedrigen Ladezustand durch verlängertes Laden lindert, und zwar so nahe wie möglich auf 100% ihrer Kapazität, was nachfolgend als Mitigation bezeichnet wird, kann als Strategie für elektrische Robustheit bezeichnet werden. Diese Strategie setzt im Falle eines niedrigen Ladezustands einen Spannungseinstellungspunkt außer Kraft, der möglicherweise durch die Strategie zum Verbessern des Energieumwandlungswirkungsgrades festgesetzt wird, und stellt daher in der Hierarchie zur Entscheidung über den Spannungseinstellungspunkt der Lichtmaschine die höchste Instanz dar.

In Hybrid- und Elektrofahrzeugen erfolgt die Niederspannungsversorgung häufig über einen Gleichspannungskonverter, der von einem Hochspannungsnetzwerk versorgt wird. In diesem Fall kann der Teil der Erfindung, der den Batterieladezustand überwacht, auch in diesen Fahrzeugen durch die Aktivierung eines geeigneten Spannungseinstellungspunktes des Gleichspannungskonverters implementiert werden, um die elektrische Robustheit der Niederspannungsversorgung zu gewährleisten.

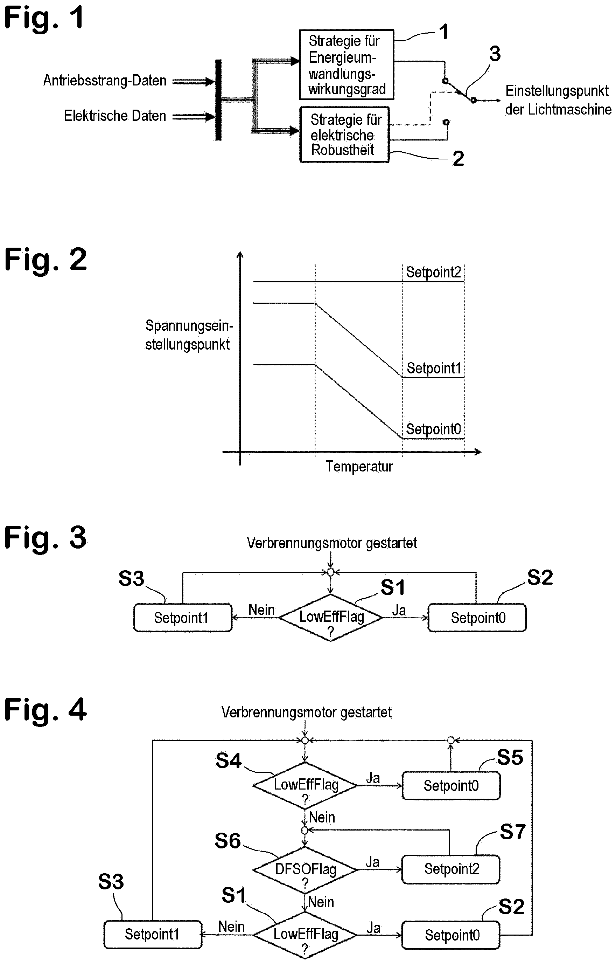

Fig. 1 ist ein Überblick über eine Lichtmaschinen-Steuerarchitektur mit einem Batteriemanagementsystem, d.h. über die Architektur zur Steuerung der Auswahl der Strategie zum Festsetzen des Spannungseinstellungspunktes der Lichtmaschine, und veranschaulicht die Kombination einer Strategie 1 zum Verbessern des Energieumwandlungswirkungsgrades mit einer Strategie 2 für elektrische Robustheit in einer kombinierten Steuerarchitektur. Beide Strategien basieren auf Daten vom Antriebstrang sowie Daten von der Fahrzeugelektrik.

Ein virtueller Umschalter 3 in Fig. 1, der den Ursprung des Spannungseinstellungspunktes der Lichtmaschine steuert, spiegelt die duale Verantwortlichkeit der minimalen Stromversorgungs-Managementstrategie wider, nämlich den Kraftstoffverbrauch und $CO_2$-Emissionen zu verbessern und Robustheit der elektrischen Stromversorgung aufrechtzuerhalten. Die gestrichelte Linie zwischen dem virtuellen Umschalter 3 und der Strategie 2 für elektrische Robustheit zeigt die Stellung der Letzteren in der Hierarchie zur Entscheidung über den Spannungseinstellungspunkt an.

Die Strategie 1 zum Verbessern des Energieumwandlungswirkungsgrades wird nachfolgend in zwei Abschnitten beschrieben. Im ersten Abschnitt wird die Auswahl des Spannungseinstellungspunktes der Lichtmaschine in Bezug auf die Betriebsart nach Wirkungsgrad beschrieben, d.h., in Bezug auf den Energieumwandlungswirkungsgrad des Antriebsstrangs in der gerade herrschenden Betriebsart, und im zweiten Abschnitt wird die Erkennung der Betriebsart des Antriebsstrangs (hoher Wirkungsgrad, niedriger Wirkungsgrad oder regeneratives Bremsen) beschrieben.

Für die Auswahl des Spannungseinstellungspunktes der Lichtmaschine in Bezug auf die Betriebsart nach Wirkungsgrad wird nach Inbetriebnahme des Fahrzeugs in Abhängigkeit von der Betriebsart des Antriebsstrangs ein von der Batterietemperatur abhängiger Spannungseinstellungspunkt ausgewählt. Während eines Verbrennungsmotorbetriebs sind zwei Betriebsarten möglich, nämlich mit hohem oder niedrigem Wirkungsgrad. Eine dritte Betriebsart bezieht sich auf die Situation, in der eine Verzögerung bei nicht gefeuertem Verbrennungsmotor stattfindet. Die Antriebsstrang-Steuerstrategie für nicht gefeuerte Verzögerungen wird allgemein als DFSO (Deceleration Fuel Shut Off; Verzögerung bei abgeschalteter Kraftstoffzufuhr) bezeichnet.

Jeder der drei Betriebsarten kann eine eindeutige Funktion des Spannungseinstellungspunktes von der Temperatur der Batterie zugeordnet werden. Fig. 2 zeigt die Abhängigkeit der Spannungseinstellungspunkte von der Temperatur für Betrieb des Antriebsstrangs bei hohem Wirkungsgrad, niedrigem Wirkungsgrad bzw. regenerativem Bremsen.

Die Funktion für Betrieb mit hohem Wirkungsgrad ist in Fig. 2 als *Setpoint1* bezeichnet. Eine derartige Funktion der temperaturabhängigen Spannung, die bei konventionellen Ladestrategien zum Laden einer Batterie benutzt wird, wird wegen ihrer Form als Z-Kurve bezeichnet und kann vom Batteriehersteller festgelegt werden. Die Funktion *Setpoint1* kann die temperaturabhängige Spannungskennlinie widerspiegeln, die benutzt wird, um eine Starterbatterie, welche den Strom für Anlasser, Zündung und Beleuchtung liefert, mit einer konventionellen Strategie zur Regelung der Stromzufuhr vollständig zu laden, und sie wird auch als Einstellungspunkt für hohe (d.h. relativ hohe) Spannung bezeichnet.

Die Z-Kurve für Betrieb mit niedrigem Wirkungsgrad ist in Fig. 2 als *Setpoint0* bezeichnet. Sie kann so kalibriert werden, dass sie über den ganzen Temperaturbereich um 0,3 bis 1 Volt niedriger als Setpoint1 ist, und der niedrigste Wert, nämlich jener für hohe Batterietemperatur, sollte größer sein als die Leerlaufspannung einer Batterie mit einem minimalen, aber immer noch als ausreichend geltendem Ladezustand.

Wenn der Spannungseinstellungspunkt von *Setpoint1* nach *Setpoint0* wechselt, wird die Lichtmaschine von der Bordstromversorgung entlastet, und die Batterie entlädt sich, bis das durch die Kirchhoff-Regeln gegebene Gleichgewicht erreicht ist. Daher wird die Lichtmaschine eine Zeitspanne lang entladen, die proportional zu dem Fahrzeuglaststrom ist, wenn der Wirkungsgrad von hoch nach niedrig wechselt.

Wenn eine Verzögerung bei nicht gefeuertem Verbrennungsmotor stattfindet, kann entweder *Setpoint1* oder wahlweise ein höherer Spannungseinstellungspunkt angewendet werden, der mit *Setpoint2* bezeichnet ist. *Setpoint2* kann je nach Anwendung ein temperaturabhängiger oder ein konstanter, nicht temperaturabhängiger Wert sein. Da *Setpoint2* größer als *Setpoint1* ist, beginnt die Batterie stets, geladen zu werden, wenn ein Übergang des Spannungseinstellungspunktes von *Setpoint1* nach *Setpoint2* stattfindet, und reserviert somit einen Energiepuffer für regeneratives Bremsen bei nicht gefeuertem Verbrennungsmotor.

Es werden nun Algorithmen beschrieben, auszuwählen, durch welche der in Fig. 2 gezeigten Funktionen *Setpoint0, Setpoint1* und *Setpoint2* der Spannungseinstellungspunkt bestimmt werden soll.

Fig. 3 veranschaulicht die Auswahl des Spannungseinstellungspunkts für Betriebsarten mit hohem und niedrigem Wirkungsgrad anhand eines sehr einfachen Auswahlalgorithmus für zwei Betriebsarten, nämlich mit hohem und niedrigem Wirkungsgrad. Nach dem Motorstart überwacht (S1) der Algorithmus zur Auswahl des Spannungseinstellungspunktes einen Merker für den Wirkungsgrad und wählt einen vergleichsweise niedrigen Spannungseinstellungspunkt *Setpoint0* aus (S2), wenn ein Merker LowEffFlag für niedrigen Wirkungsgrad aktiviert ist. Andernfalls wird ein vergleichsweise hoher Spannungseinstellungspunkt *Setpoint1* ausgewählt (S3). Werden zwei temperaturabhängige Spannungseinstellungspunkte benutzt, kann eine nicht gefeuerte Verzögerung als eine Betriebsart mit hohem Wirkungsgrad erkannt werden.

Fig. 4 veranschaulicht die Auswahl des Spannungseinstellungspunkts für Betriebsarten mit hohem und niedrigem Wirkungsgrad sowie für nicht gefeuerte Verzögerungen in Form einer Erweiterung des in Fig. 3 gezeigten Algorithmus zur Auswahl des Spannungseinstellungspunktes, indem für nicht gefeuerte Verzögerungen ein zusätzlicher Spannungseinstellungspunkt *Setpoint2* definiert wird, der noch höher als *Setpoint1* ist. Je nachdem, ob LowEffFlag aktiviert ist oder nicht (S4), wird entweder *Setpoint0* ausgewählt (S5) oder wird vor dem Schritt S1 von Fig. 3 noch geprüft (S6), ob ein Merker DFSOFlag für höchsten Wirkungsgrad aktiviert ist, in welchem Fall eine nicht gefeuerte Verzögerung erkannt und der Spannungseinstellungspunkt *Setpoint2* ausgewählt wird (S7).

Die Erkennung, ob sich der Antriebsstrang in einer Betriebsart mit hohem oder niedrigen Wirkungsgrad befindet, geschieht entlang der Linien der Motorsteuerstrategien, die während des Fahrzeugbetriebs aktiv sind. Daher können Betriebsarten erkannt werden, die dem Leerlauf-Controller, dem Verzögerungs-Controller, dem Schalt-Controller und dem Controller für Management des Vortriebsdrehmoments entsprechen, und diese Betriebsarten können in Abhängigkeit von deren typischer Kalibrierung als mit hohem oder niedrigem Wirkungsgrad sortiert werden. Die Betriebsarten können weiter unterteilt werden, falls die entsprechenden Energieumwandlungswirkungsgrade wesentlich variieren.

Bei einem Ottomotor ist der Energieumwandlungswirkungsgrad eine Funktion der Vorzündung und des Luft/Kraftstoff-Verhältnisses wie in der folgenden Formel beschrieben:

$$BMEP = G_f\, q\, \eta(\varphi), \text{ worin} \qquad\qquad (1)$$

*BMEP* den mittleren Druck im Zylinder während des Verbrennungszyklus (Brake Mean Effective Pressure) repräsentiert, q die Menge des eingespritzten Kraftstoffs (Kraftstoffmassenfluss) repräsentiert, $G_f$ einen vom Luft/Kraftstoff-Verhältnis abhängigen Ausbeutefaktor repräsentiert und $\eta(\varphi)$ die Zündungswirkungsgradfunktion (Wirkungsgrad in Bezug auf Vorzündung $\varphi$) repräsentiert, vgl. Ballichi, Benvenuti, Di Benedetto, Pinello, Sangiovanni-Vincentelli, "Automotive Engine Controls and Hybrid Systems: Challenges and Opportunities", Proceedings of the IEEE, Juli 2000.

Nach dem Aufwärmen des Verbrennungsmotors wird das Luft/Kraftstoff-Verhältnis nahe an einem stöchiometrischen Wert gehalten, doch wird die Vorzündung auf weniger effiziente Werte ($\eta(\varphi)<1$) verändert. Daher kann eine Klassifizierung der Betriebsarten in Bezug auf den Energieumwandlungswirkungsgrad in Bezug auf die Zündungs-Wirkungsgradfunktion durchgeführt werden.

Die Zündungs-Wirkungsgradfunktion hat ihren Maximalwert, wenn für ein gegebenes Luft/Kraftstoff-Verhältnis der höchste mittlere Druck im Zylinder (BMEP) erreicht ist. Bei diesem Maximalwert sagt man, die Vorzündung hat den Einstellwert MBT (Mean Best Torque; mittleres bestes Drehmoment). In einigen Betriebsarten wählt die Motorkalibrierung absichtlich Vorzündungswerte aus, die nicht MBT entsprechen, um für eine Drehmomentreserve zu sorgen, eine hohe Verbrennungsstabilität aufrechtzuerhalten, hohe $NO_x$-Emissionspegel zu vermeiden oder Motorklopfen zu vermeiden. Diese Betriebsarten können von der Stromversorgungs-Managementstrategie als für die Erzeugung von elektrischer Energie ungeeignet klassifiziert werden, weil dabei ein niedriger Energieumwandlungswirkungsgrad herrscht. Andererseits sind Betriebsarten, bei denen durch die Kalibrierung eine MBT-Vorzündung erhalten wird, für die Energieerzeugung günstig, da aus einer Masseneinheit Kraftstoff mehr arbeitsbedingte Energie erhalten werden kann.

Die Klassifizierung der Betriebsarten als günstig oder ungünstig für die Energieerzeugung kann man durchführen, indem man Kalibrierungsanleitungen untersucht und Kalibrierungsexperten konsultiert, um Betriebsarten zu identifizieren, in denen entweder eine MBT-Vorzündungseinstellung immer oder häufig gewählt wird oder in denen die Vorzündung wesentlich verzögert wird. Während des Fahrzeugbetriebs erfolgt die Identifizierung der günstigen oder ungünstigen Betriebsarten einfach durch Überwachung der Steuereingangssignale und Statusmeldungen des Antriebsstrangs. Wenn bestimmte Bedingungen (z.B. Motordrehzahl, Drosselklappenposition etc.) auftreten, die eine Betriebsart oder Controller-Strategie anzeigen, die als günstig oder ungünstig angesehen wird, wird ein Spannungseinstellungspunkt der Lichtmaschine gewählt, der die Energieerzeugung entweder fördert oder hemmt.

Eine bevorzugte Implementierung der minimalen Stromversorgungs-Managementstrategie bei einem Kraftfahrzeug mit Ottomotor kann zwischen den Wirkungsgraden im Leerlauf, nach einem Start aus verlängertem Leerlauf, Vortrieb (mit gleich bleibender Geschwindigkeit oder beschleunigt, aber kein Start aus dem Leerlauf), Drosselklappe ganz offen und nicht gefeuerten Verzögerungen unterscheiden. Davon werden Leerlauf, Start aus verlängertem Leerlauf und Drosselklappe ganz offen als Betriebsarten mit niedrigem Energieumwandlungswirkungsgrad klassifiziert. Die übrigen Betriebsarten, nämlich Vortrieb mit Beschleunigung oder gleich bleibender Geschwindigkeit, werden als Betriebsarten mit hohem Energieumwandlungswirkungsgrad klassifiziert.

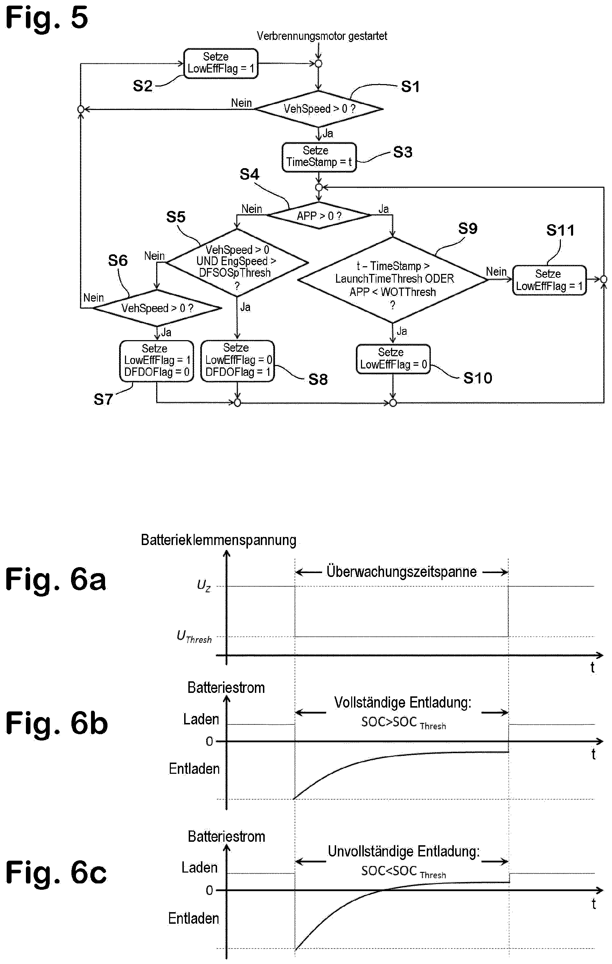

Fig. 5 veranschaulicht einen Algorithmus, der die Betriebsart nach Wirkungsgrad im Falle eines durch einen Ottomotor angetriebenen Antriebsstrangs ermittelt. Die Erkennung dieser Betriebsarten einschließlich nicht gefeuerter Verzögerungen verlangen die Kenntnis der Fahrpedalposition (APP in Fig. 5), der Fahrzeuggeschwindigkeit (VehSpeed in Fig. 5) und der Motordrehzahl (EngSpeed in Fig. 5). Die Motordrehzahl kann anhand der Fahrzeuggeschwindigkeit und der vom Fahrer oder Getriebe-Controller gewählten Positionen von Gangwähler und Kupplungspedal geschätzt werden.

Die Ausgangsgrößen des Algorithmus zur Erkennung der Betriebsart nach Wirkungsgrad sind die Merker LowEffFlag und DFSOFlag. Kalibrierte Parameter DFSOSpThresh und WOTThresh werden mit der Motordrehzahl verglichen, um zu ermitteln, ob eine nicht gefeuerte Verzögerung stattfindet oder ob das Fahrpedal weit genug niedergedrückt ist, um einen Betrieb mit ganz offener Drosselklappe zu erkennen. Die Merker LowEffFlag und DFSOFlag werden von den in Figuren 3 und 4 veranschaulichten Algorithmen zur Auswahl des Spannungseinstellungspunktes benutzt, um den Spannungseinstellungspunkt festzulegen, der als Befehl an die Lichtmaschine gesendet wird.

Insbesondere wird in Übereinstimmung mit Fig. 5 nach dem Motorstart geprüft, ob die Fahrzeuggeschwindigkeit VehSpeed größer als null ist (S1). Wenn nein, wird LowEffFlag auf 1 gesetzt (S2), und der Schritt S1 wird von Neuem durchgeführt. Wenn ja, wird der aktuelle Zeitpunkt t als ein Zeitstempel TimeStamp gespeichert (S3), und es wird geprüft, ob die Fahrpedalposition APP größer als null ist (S4). Wenn nein, wird geprüft, ob die Fahrzeuggeschwindigkeit VehSpeed immer noch größer als null ist und gleichzeitig die Motordrehzahl EngSpeed größer als DFSOSpThresh ist (S5). Wenn nein, wird geprüft, ob die Fahrzeuggeschwindigkeit VehSpeed immer noch größer als null ist (S6). Wenn nein, geht es zum Schritt S2 zurück. Wenn ja, wird LowEffFlag auf 1 gesetzt und wird und DFSOFlag auf 0 gesetzt (S7), und es geht zum Schritt S4 zurück. Bei ja im Schritt S5 wird LowEffFlag auf 0 gesetzt und wird DFSOFlag auf 1 gesetzt (S8), und es geht zum Schritt S4 zurück. Bei ja im Schritt S4 wird geprüft, ob die Differenz zwischen dem nun aktuellen Zeitpunkt t und dem im Schritt S3 gesetzten Zeitstempel TimeStamp größer als ein Schwellenwert LaunchTimeThresh ist oder ob die Fahrpedalposition APP kleiner als WOTThresh ist (S9). Bei ja im Schritt S9 wird LowEffFlag auf 0 gesetzt (S10), und es geht zum Schritt S4 zurück. Bei nein im Schritt S9 wird LowEffFlag auf 1 gesetzt (S11), und es geht zum Schritt S4 zurück.

Ein ähnlicher Satz von Bedingungen, um Betriebsarten mit niedrigem und hohem Wirkungsgrad und nicht gefeuerte Verzögerungen zu erkennen, kann für einen Dieselmotor aufgestellt werden, und die Betriebsarten nach Wirkungsgrad können wie im Falle eines Ottomotors anhand der Fahrpedalposition, der Positionen von Gangwähler und Kupplungspedal sowie der Fahrzeuggeschwindigkeit als Eingangsgrößen erkannt werden.

Die Strategie für elektrische Robustheit überwacht den Ladezustand der Batterie mit Hilfe eines Merkers LowSOcFlag für niedrigen Ladezustand und startet Laden auf einem relativ hohen Spannungseinstellungspunkt (Setpoint1 in Fig. 2), wenn ein niedriger Ladezustand erkannt wird. Die Strategie für elektrische Robustheit kann in drei Funktionen unterteilt werden: Erkennung eines niedrigen Ladezustands, Management (Setzen und Rücksetzen) von Mitigation und des Merkers LowSOcFlag, und Steuerung des Spannungseinstellungspunktes zum Laden der Batterie.

In einem Beispiel, das nicht Gegenstand der Patentansprüche ist, kann ein konventioneller, in der Pol-Nische montierter Batterieüberwachungssensor benutzt werden, um den Ladezustand der Batterie kontinuierlich zu überwachen. Der geschätzte Ladezustand, welcher der Strategie übermittelt wird, kann durch die Funktion zum Management eines niedrigen Ladezustands mit einem kalibrierten Schwellenwert verglichen werden, um die Mitigationsstrategie zu aktivieren oder zu deaktivieren.

Erkennung eines niedrigen Ladezustands mittels eines Algorithmus für die Erkennung eines niedrigen Ladezustands

Alternativ kann die hier beschriebene minimale Stromversorgungs-Managementstrategie in Verbindung mit einem Algorithmus implementiert werden, der keinen konventionellen Batterieüberwachungssensor benötigt, um den Ladezustand zu schätzen. Derartige Algorithmen überwachen die Ausgangsgröße(n) der Quelle für elektrischen Strom im Kraftfahrzeug (der Lichtmaschine) während periodischer oder sporadischer Übergänge von einem Spannungseinstellungspunkt zu einem anderen, und dieselben Übergänge von relativ hohen zu relativ niedrigen Spannungseinstellungspunkten, die zum Verbessern des Energieumwandlungswirkungsgrades durchgeführt werden, wie oben beschrieben, können auch dazu benutzt werden, den Ladezustand zu schätzen.

Ein hier bevorzugter derartiger Algorithmus ist ein Algorithmus für diskrete Erkennung eines niedrigen Ladezustands, der den Batteriezustand ohne einen konventionellen Batterieüberwachungssensor oder durch Messung des Batteriestroms schätzt, ermöglicht eine diskrete Erkennung des Batterieladezustands anhand eines von dem Algorithmus ausgegebenen Merkers, der anzeigt, ob der Ladezustand unterhalb oder oberhalb eines kalibrierten Schwellenwertes liegt.

Wird ein derartiger Algorithmus für diskrete Erkennung eines niedrigen Ladezustands, nachfolgend auch diskreter Algorithmus genannt, in Verbindung mit der hier beschriebenen minimalen Stromversorgungs-Managementstrategie implementiert, finden die Übergänge von relativ hohen zu relativ niedrigen Spannungseinstellungspunkten statt, wenn der Energieumwandlungswirkungsgrad des Antriebsstrangs von hoch nach niedrig wechselt oder wenn eine Rekuperationsphase in einer Betriebsart mit niedrigem Energieumwandlungswirkungsgrad endet. Die Übergänge und die Ladezustandsprüfung finden hier sporadisch als eine Funktion des Fahrzyklus statt. Dabei kann der Algorithmus für diskrete Erkennung eines niedrigen Ladezustands periodische Spannungs-absenkungen erzeugen, wenn über eine lange Zeitspanne kein ohnehin auftretender Übergang stattfindet, wie es der Fall sein kann, wenn das Fahrzeug mit Tempomat auf einer Autobahn betrieben wird. Solange die Richtlinien befolgt werden, die in dem obigen Abschnitt "Auswahl des Spannungseinstellungspunktes der Lichtmaschine in Bezug auf die Betriebsart nach Wirkungsgrad" sowie in dem nachfolgenden Abschnitt "Merker für niedrigen Ladezustand und Mitigations-Management" dargelegt sind, und die Stromquelle (die Lichtmaschine) nicht gesättigt ist, ist aber keine häufige Überwachung des Ladezustands erforderlich.

Der diskrete Algorithmus erkennt einen niedrigen Ladezustand durch Überwachung des Batteriestroms während eines Übergangs von einem relativ hohen zu einem relativ niedrigen Spannungseinstellungspunkt während einer kalibrierten Zeitspanne. Diese Zeitspanne muss so lang sein, dass sich die kapazitiven Elemente des Äquivalenzschaltungsmodells der Batterie vollständig entladen können, falls der Ladezustand der Batterie niedriger als der kalibrierte Schwellenwert ist. Dieser Schwellenwert für den Ladezustand ist eine Funktion des relativ niedrigen Spannungseinstellungspunkts, welcher durch den Spannungseinstellungspunkt für Betriebsarten mit niedrigem Energieumwandlungswirkungsgrad repräsentiert wird.

Falls der Ladezustand der Batterie den kalibrierten Schwellenwert übersteigt, muss sich die Batterie entladen und darf während der kalibrierten Überwachungszeitspanne, die am Übergang des Spannungseinstellungspunkts von relativ hoch nach relativ niedrig beginnt, nicht mehr anfangen, geladen zu werden. Um den Ladezustand als oberhalb des kalibrierten Schwellenwertes erkennen zu können, kann hier während der Überwachungszeitspanne daher nur der Entladestrom gemessen werden. Dies entspricht dem Umstand, dass der Merker LowSOcFlag auf 0 gesetzt ist. Andernfalls, wenn ein Laden der Batterie detektiert wird, wird der Ladezustand als unterhalb des kalibrierten Schwellenwertes erkannt, und der Merker LowSOcFlag wird auf 1 gesetzt.

Figuren 6a bis 6c zeigen die Batterieklemmenspannung und den Batteriestrom während einer Überwachungszeitspanne für eine Batterie mit einem Ladezustand oberhalb und unterhalb des kalibrierten Schwellenwertes. Fig. 6a zeigt ein Beispiel für eine Batterieklemmenspannung, die während der Spannungseinstellungspunkt-Steuerung zwischen einem Wert $U_Z$, welcher der temperaturabhängigen Ausgleichsladespannung entspricht, und einem dem kalibrierten Schwellenwert $SOC_{Thresh}$ entsprechenden Wert $U_{Thresh}$ wechselt. Fig. 6b zeigt den resultierenden Batteriestrom für eine Batterie mit einem Ladezustand SOC oberhalb des kalibrierten Schwellenwertes $SOC_{Thresh}$. Fig. 6c zeigt den resultierenden Batteriestrom für eine Batterie mit einem Ladezustand SOC unterhalb des kalibrierten Schwellenwertes $SOC_{Thresh}$. Zu Beginn der Überwachungszeitspanne entlädt sich die Batterie mit einem Strom, der durch die Werte der resistiven und kapazitiven Elemente des Äquivalenzschaltungsmodells der Batterie bestimmt wird.

Der Batteriestrom kann mittels eines Hall-Effekt-Sensors direkt gemessen werden, was nicht Gegenstand der Patentansprüche ist, oder er kann mit Hilfe des Ausgangsstroms oder Tastverhältnisses der Lichtmaschine indirekt überwacht werden. Da der Innenwiderstand der Batterie wesentlich kleiner als jener einer Lichtmaschine ist, versorgt sie nach einem Übergang von einem relativ hohen zu einem relativ niedrigen Spannungseinstellungspunkt sämtliche Lasten, bis die Leerlaufspannung dem niedrigen Spannungseinstellungspunkt gleicht. In diesem Zeitpunkt versorgt die Lichtmaschine sämtliche Lasten, indem sie der Last folgt. Doch wenn der Ausgangsstrom der Lichtmaschine null ist, oder wenn ihr Tastverhältnis auf einem Minimalwert ist, kann angenommen werden, dass die Batterie gerade entladen wird. Auf diese Weise kann der Batteriestrom mittels Signalen, die den Ausgangsstrom der Lichtmaschine charakterisieren und die auf dem CAN-Bus im Fahrzeug immer allgemein verfügbar sind, indirekt überwacht werden

Je nachdem, ob die Erkennung eines niedrigen Ladezustands mit einem konventionellen, in der Pol-Nische montierten Batterieüberwachungssensor, der den Ladezustand direkt schätzt, was nicht Gegenstand der Patentansprüche ist, oder ob ein Algorithmus für diskrete Erkennung eines niedrigen Ladezustands benutzt wird, der den Batteriestrom indirekt überwacht, wie oben beschrieben, können unterschiedliche Strategien für Mitigation eines niedrigen Ladezustands realisiert werden.

Ein Teil der Strategie für Mitigation eines niedrigen Ladezustands ist das Management des Merkers für niedrigen Ladezustand (LowSOcFlag) einschließlich seiner Rücksetzbedingungen. Der Merker für niedrigen Ladezustand sollte in nichtflüchtigem Speicher gespeichert werden, damit Mitigation über mehr als eine Fahrphase stattfinden kann. Dies deswegen, weil Fahrten oft nicht lange genug dauern, um eine Batterie zu laden.

Mitigation besteht darin, die Batterie mit einer temperaturabhängigen Spannung zu laden, die ausreicht, um in allen Zellen eine vollständige Ladung zu erreichen. Wie in Fig. 1 veranschaulicht, wird der Spannungseinstellungspunkt in Bezug auf die Betriebsart des Antriebsstrangs nach Wirkungsgrad während einer Mitigation eines niedrigen Ladezustands nicht geändert. Stattdessen wird ein relativ hoher Spannungseinstellungspunkt angewendet, welcher der in Fig. 2 als Setpoint1 bezeichneten temperaturabhängigen Z-Kurve entspricht. Wie oben im Zusammenhang mit der Auswahl des Spannungseinstellungspunktes der Lichtmaschine in Bezug auf die Betriebsart nach Wirkungsgrad beschrieben, beschreibt die dem Setpoint1 entsprechende Z-Kurve eine temperaturabhängige Spannungskennlinie, die benutzt wird, um eine Starterbatterie mit einer konventionellen Strategie zur Regelung der Stromzufuhr vollständig zu laden. Sie kann vom Batteriehersteller oder vom Fahrzeughersteller festgelegt werden.

Merker für niedrigen Ladezustand und Mitigations-Management mittels eines konventionellen Batteriemanagementsystems

Wird ein konventioneller, in der Pol-Nische montierte Batterieüberwachungssensor benutzt, kann der Merker LowSOcFlag gesetzt werden, indem der mittels des Sensors geschätzte Ladezustand mit einem kalibrierten Schwellenwert LowSOCThresh verglichen wird. Die Bedingung 'niedriger Ladezustand' kann aufgehoben werden, indem der Ladezustand mit einem zweiten Schwellenwert HighSOCThresh verglichen wird, der genügend höher als LowSOCThresh kalibriert werden kann, um ein Pendeln zwischen gesetzter und nicht gesetzter Bedingung 'niedriger Ladezustand' zu vermeiden.

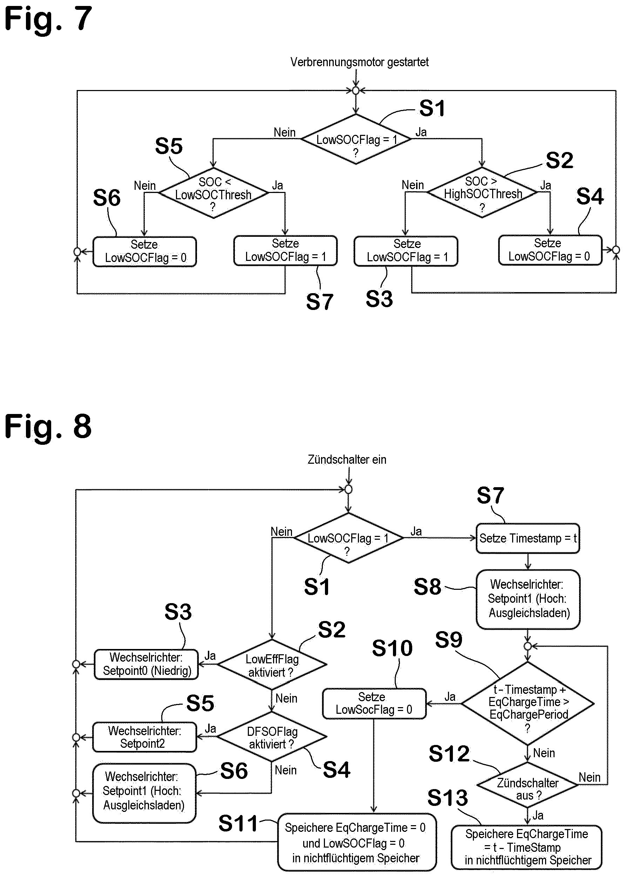

Fig. 7 veranschaulicht das Management des Merkers LowSOcFlag bei der hierin beschriebenen minimalen Stromversorgungs-Managementstrategie unter Verwendung der Ausgangsgröße eines konventionellen, in der Pol-Nische montierten Batterieüberwachungssensors.

Wenn der Merker LowSOcFlag aktiviert ist und Mitigation stattfindet, wird nur ein relativ hoher temperaturabhängiger Spannungseinstellungspunkt angewendet, der in Fig. 2 als Setpoint1 bezeichnet ist. Andernfalls können relativ niedrige oder höhere Spannungseinstellungspunkte angewendet werden, um das Laden der Batterie zu hemmen oder zu fördern, wie in dem obigen Abschnitt "Auswahl des Spannungseinstellungspunktes der Lichtmaschine in Bezug auf die Betriebsart nach Wirkungsgrad" beschrieben.

Insbesondere wird in Übereinstimmung mit Fig. 7 nach dem Motorstart geprüft, ob LowSOcFlag gleich 1 ist (S1), und wenn ja, wird geprüft, ob der Ladezustand SOC höher als HighSOCThresh ist (S2). Wenn nein, bleibt Low-SOcFlag weiter auf 1 (S3), und es geht zum Schritt S1 zurück. Wenn ja, wird LowSOcFlag auf 0 gesetzt (S4), und es geht zum Schritt S1 zurück. Wenn nein im Schritt S1, wird geprüft, ob der Ladezustand SOC niedriger als LowSOCThresh ist (S5). Wenn ja, bleibt LowSOcFlag weiter auf 1 (S6), und es geht zum Schritt S1 zurück. Wenn nein, wird LowSOcFlag auf 0 gesetzt (S7), und es geht zum Schritt S1 zurück.

Merker für niedrigen Ladezustand und Mitigations-Management mittels des Algorithmus für diskrete Erkennung eines niedrigen Ladezustands

Wird der weiter oben beschriebene Algorithmus für diskrete Erkennung eines niedrigen Ladezustands benutzt, um den Batterieladezustand zu überwachen, kann der Merker LowSOcFlag direkt durch den Erkennungsalgorithmus gesetzt werden. In diesem Fall wird ein relativ hoher temperaturabhängiger Spannungseinstellungspunkt angewendet, wie in Fig. 2 als Setpoint1 bezeichnet, bis die Bedingung 'niedriger Ladezustand' durch die Mitigationsstrategie aufgehoben wird.

Es gibt zwei Möglichkeiten, die Bedingung 'niedriger Ladezustand' aufzuheben. Der Algorithmus für diskrete Erkennung eines niedrigen Ladezustands kann in Verbindung mit kurzzeitigen Absenkungen des Spannungseinstellpunkts periodisch angewendet werden. Während und nach den Spannungsübergängen von hoch nach niedrig kann der Algorithmus benutzt werden, um zu ermitteln, ob der Ladungszustand den kalibrierten Schwellenwert für niedrigen Ladungszustand wieder überstiegen hat. Wird diese Strategie für das Mitigations-Management benutzt, sollte der Ladungszustand-Schwellenwert, der benutzt wird, um die Bedingung 'niedriger Ladezustand' aufzuheben, wesentlich höher kalibriert werden als der Schwellenwert, der benutzt wird, um einen niedrigen Ladezustand zu erkennen, um ein Pendeln zwischen gesetzter und nicht gesetzter Bedingung 'niedriger Ladezustand' zu vermeiden und um die Robustheit zu verbessern.

Eine bevorzugte Mitigationsstrategie, die in Verbindung mit diskreter Erkennung von eines niedrigen Ladezustands benutzt werden kann, ist es, das Laden mit einem relativ hohen temperaturabhängigen Spannungseinstellpunkt durchzuführen, und zwar während einer langen, kalibrierten Zeitspanne EqChargePeriod. Mitigation durch Laden während einer langen, vordefinierten Zeitspanne kann auch auf Ausführungen mit einem konventionellen Batterieüberwachungssensor, oben beschriebenen, angewendet werden.

Die kalibrierte Ladezeit EqChargePeriod für Mitigation eines niedrigen Ladezustands kann als Ausgleichsladezeitspanne bezeichnet werden, da sie lang genug sein sollte, um alle Zellen der Batterie gleichmäßig auf 100% ihrer Kapazität zu laden. Die Ausgleichsladezeitspanne sollte eine Größe von mehreren Stunden haben und wird normalerweise mehrere Fahrten umfassen. Um die mit Mitigation verbrachte Zeit verfolgen zu können, sollte deren Wert EqChargeTime, der mit dem bei der Managementstrategie benutzten Timer gemessen wird, in nichtflüchtigem Speicher gespeichert werden.

Fig. 8 veranschaulicht eine vollständige minimale Stromversorgungs-Managementstrategie unter Verwendung einer Strategie für Mitigation eines niedrigen Ladezustands, welche die Ladezeit unter Verwendung eines Timers verwaltet. Es wird angenommen, dass die Bedingung 'niedriger Ladezustand' mit dem oben beschriebenen Algorithmus für diskrete Erkennung eines niedrigen Ladezustands erkannt wird und dass der Merker für niedrigen Ladezustand (LowSOcFlag) und die Ausgleichsladezeitspanne (EqChargeTime) anfänglich auf 0 gesetzt sind.

Die in Fig. 8 veranschaulichte minimale Stromversorgungs-Managementstrategie vereinigt die Strategie zur Verbesserung des Energieumwandlungswirkungsgrades mit der Strategie zur Mitigation eines niedrigen Ladezustands.

Die im Flussdiagramm von Fig. 8 benutzten Zustände des Merkers LowEffFlag für niedrigen Wirkungsgrad und des Merkers DFSOFlag für höchsten Wirkungsgrad, der eine Verzögerung bei abgeschalteter Kraftstoffzufuhr kennzeichnet, werden durch den in Fig. 5 veranschaulichten Algorithmus für Erkennung der Betriebsart nach Wirkungsgrad definiert.

Nach dem Einschalten des Fahrzeugzündschalters zum Starten des Verbrennungsmotors wird zunächst im Schritt S1 von Fig. 8 geprüft, ob der Merker LowSOCFlag auf 1 gesetzt ist.

Wenn nein, ist keine Mitigation nötig, und es wird die Strategie zur Verbesserung des Energieumwandlungswirkungsgrades angewendet. Dazu wird geprüft, ob der Merker LowEffFlag aktiviert ist (S2). Wenn ja, wird der vergleichsweise niedrige Spannungseinstellungspunkt Setpoint0 ausgewählt (S3). Wenn nein, wird geprüft, ob der Merker DFSOFlag aktiviert ist (S4). Wenn ja, wird der sehr hohe Spannungseinstellungspunkt Setpoint2 ausgewählt (S5). Wenn nein, wird der Spannungseinstellungspunkt Setpoint1 ausgewählt (S6), welcher zwischen Setpoint0 und Setpoint1 liegt. Dies entspricht im Ergebnis der in Fig. 4 veranschaulichten Auswahlstrategie. Die Lichtmaschine wird nun mit dem ausgewählten Spannungseinstellungspunkt betrieben, um den optimalen Energieumwandlungswirkungsgrad zu erzielen, es geht mit dem Schritt S1 weiter.

Falls der Schritt S1 von Fig. 8 ergibt, dass der Merker LowSOcFlag nicht auf 1 gesetzt ist, wird der aktuelle Zeitpunkt t als ein Zeitstempel TimeStamp gesetzt (S7), und es wird der vergleichsweise hohe Spannungseinstellungspunkt Setpoint1 für Ausgleichsladen ausgewählt, mit dem die Lichtmaschine nun betrieben wird (S8). Danach wird geprüft, ob die nach den Schritt S7 verstrichene Zeit (t - TimeStamp) plus die Ausgleichsladezeit EqChargeTime größer als die Ausgleichsladezeit EqChargePeriod ist (S9). Wenn ja, wird der Merker LowSOcFlag auf 0 gesetzt (S10), und die Werte EqChargeTime = 0 und LowSOcFlag = 0 werden in einem nichtflüchtigen Speicher gespeichert (S11). Wenn nein, wird geprüft, ob der Fahrzeugzündschalter ausgeschaltet ist (S11). Wenn nein, wird die Prüfung im Schritt S9 wiederholt. Wenn ja, wird der Wert EqChargeTime = t - TimeStamp in dem Speicher gespeichert (S12).

D.h., zur Mitigation eines niedrigen Ladezustands wird die Batterie unter Verwendung einer relativ hohen Spannung über die vorbestimmte Zeitspanne EqChargePeriod geladen, und dies wird auch fortgesetzt, wenn die Fahrt unterbrochen wurde. Erst wenn die Mitigation beendet ist, wird wieder die Strategie zur Verbesserung des Energieumwandlungswirkungsgrades angewendet, die eine für den Energieumwandlungswirkungsgrad optimale Ladespannung erzeugt.

In einer Variante der in Fig. 8 gezeigten Strategie kann im Schritt S8 alternativ der ganz hohe Spannungseinstellungspunkt Setpoint2 ausgewählt werden, falls gerade regeneratives Bremsen stattfindet, d.h., falls der Merker DFSOFlag aktiviert ist. Doch könnte Setpoint2 weniger günstig sein, falls die Batterie beinahe voll geladen ist.

Soll die in Fig. 8 gezeigten Strategie für ein Kraftfahrzeug ohne regeneratives Bremssystem verwendet werden, entfallen einfach die Schritte S5 und S4, und es geht vom Schritt S2 direkt zum Schritt S6.

Die hierin beschriebene minimale Stromversorgungs-Managementstrategie kann bei einem beliebigen Typ von Kraftfahrzeug durchgeführt werden, das von einem Verbrennungsmotor angetrieben wird, um den Kraftstoffverbrauch und den Schadstoffausstoß zu verbessern. Die Erkennung der Wirkungsgrad-Betriebsarten, die benutzt werden, um den Spannungseinstellungspunkt der Lichtmaschine festzusetzen, sollte entlang der Linien der Motorsteuerstrategien durchgeführt werden, die Betriebsarten mit unterschiedlichen Wirkungsgraden sind, die im Fahrzeugbetrieb auftreten können.

**Patentansprüche**

1. Verfahren zum Management der elektrischen Stromversorgung in einem Kraftfahrzeug mit Verbrennungsmotor, wobei der Ladezustand einer Batterie, die mindestens den Strom für Anlasser, Zündung und Beleuchtung bereitstellen kann, als eine diskrete Größe (LowSOcFlag) erfasst wird, welche anzeigt, ob der aktuelle Ladezustand unterhalb oder oberhalb eines kalibrierten Schwellenwertes (LowSOCThresh) liegt, wobei, wenn die diskrete Größe anzeigt (S1 in Fig. 8), dass der aktuelle Ladezustand unterhalb des kalibrierten Schwellenwertes liegt, ein Laden der Batterie unter Verwendung einer relativ hohen Spannung (*Setpoint1*) über einen vorbestimmten Zeitraum durchgeführt wird (S7-S13 in Fig. 8), wobei die relativ hohe Spannung und der vorbestimmte Zeitraum eine Ausgleichsladespannung und eine Ausgleichsladezeitspanne sind, die erforderlich sind, um alle Zellen der Batterie gleichmäßig und vollständig zu laden, und wobei, wenn die diskrete Größe anzeigt, dass der aktuelle Ladezustand oberhalb des kalibrierten Schwellenwertes liegt, in Abhängigkeit von einem aktuellen Energieumwandlungswirkungsgrad eines Antriebsstrangs, der als eine weitere diskrete Größe (LowEffFlag) erfasst wird, unterschiedliche von der Batterietemperatur abhängige Spannungseinstellungspunkte (*Setpoint0, Setpoint1, ...*) einer Lichtmaschine im Fahrzeug eingestellt werden (S2-S6 in Fig. 8),
   **dadurch gekennzeichnet, dass**
   die diskrete Größe (LowSOcFlag), welche anzeigt, ob der aktuelle Ladezustand unterhalb oder oberhalb des kalibrierten Schwellenwertes (LowSOCThresh) liegt, mittels eines Algorithmus für diskrete Erkennung eines niedrigen Ladezustands erzeugt wird, welcher einen niedrigen Ladezustand durch Überwachung des Batteriestroms während eines Übergangs von einem relativ hohen zu einem relativ niedrigen Spannungseinstellungspunkt während einer vorbestimmten Zeitspanne erkennt, wobei der Batteriestrom nicht mittels eines Sensors direkt gemessen wird, sondern mit Hilfe des Ausgangsstroms oder Tastverhältnisses der Lichtmaschine indirekt überwacht wird, und dass die von der Batterietemperatur abhängigen Spannungseinstellungspunkte (*Setpoint0, Setpoint1, ...*) jeweils eindeutige Funktionen der eingestellten Ausgangsspannung der Lichtmaschine von der Temperatur der Batterie sind.

2. Verfahren nach Anspruch 1,
   **dadurch gekennzeichnet, dass**
   die relativ hohe Spannung (Setpoint1) zum vollständigen Laden der Batterie einer der mehreren von der Batterietemperatur abhängigen Spannungseinstellungspunkte (Setpoint0, Setpoint1, ...) der Lichtmaschine ist.

3. Verfahren nach Anspruch 1 oder 2,
   **dadurch gekennzeichnet, dass**
   die von der Batterietemperatur abhängigen Spannungseinstellungspunkte genau eine Funktion (*Setpoint0*) für Betrieb mit niedrigen Energieumwandlungswirkungsgrad des Antriebsstrangs sowie eine Funktion (*Setpoint1*) für Betrieb mit hohem Energieumwandlungswirkungsgrad des Antriebsstrangs umfassen.

4. Verfahren nach Anspruch 3,
   **dadurch gekennzeichnet, dass**
   die von der Batterietemperatur abhängigen Spannungseinstellungspunkte außerdem eine Funktion (*Setpoint2*) für Betrieb der Batterie als Energiepuffer für regeneratives Bremsen umfassen, wobei die Auswahl des Spannungseinstellungspunkts nicht nur anhand der weiteren diskreten Größe (LowEffFlag) erfolgt, die den aktuellen Energieumwandlungswirkungsgrad als niedrig oder hoch charakterisiert, sondern auch anhand noch einer diskreten Größe (DFSOFlag), die den aktuellen Energieumwandlungswirkungsgrad als aufgrund von der Verzögerung des Fahrzeugs ohne Kraftstoffzufuhr sehr hoch charakterisiert.

5. Verfahren nach einem der vorhergehenden Ansprüche,
   **dadurch gekennzeichnet, dass**
   die Erkennung des Energieumwandlungswirkungsgrades des Antriebsstrangs als niedrig oder hoch oder sehr hoch durch Überwachung von Steuereingangssignalen und Statusmeldungen des Antriebsstrangs erfolgt, insbesondere anhand der Fahrpedalposition (APP), der Fahrzeuggeschwindigkeit (VehSpeed) und der Motordrehzahl (EngSpeed).

6. Verfahren nach einem der vorhergehenden Ansprüche,
   **dadurch gekennzeichnet, dass**
   die diskrete Größe (LowSOCFlag), welche anzeigt, ob der aktuelle Ladezustand unterhalb oder oberhalb des Schwellenwertes liegt, sowie ggf. eine bis dahin verstrichene Batterieladezeit (EqChargeTime) in einem Speicher gespeichert werden, in dem sie bei abgestelltem Fahrzeug nicht verloren gehen, und dass das Verfahren mit der so gespeicherten diskreten Größe (LowSOCFlag) fortgesetzt wird, wenn das Fahrzeug neu gestartet wird.

**7.** Vorrichtung zum Management der elektrischen Stromversorgung in einem Kraftfahrzeug mit Verbrennungsmotor, wobei die Vorrichtung Mittel aufweist, die dazu ausgebildet sind den Ladezustand einer Batterie, die mindestens den Strom für Anlasser, Zündung und Beleuchtung bereitstellen kann, als eine diskrete Größe (LowSOCFlag) zu erfassen, welche anzeigt, ob der aktuelle Ladezustand unterhalb oder oberhalb eines kalibrierten Schwellenwertes (LowSOCThresh) liegt, wobei die Mittel ferner dazu ausgebildet sind, wenn die diskrete Größe anzeigt (S1 in Fig. 8), dass der aktuelle Ladezustand unterhalb des kalibrierten Schwellenwertes liegt, ein Laden der Batterie unter Verwendung einer relativ hohen Spannung (Setpoint1) über einen vorbestimmten Zeitraum durchzuführen (S7-S13 in Fig. 8), wobei die relativ hohe Spannung und der vorbestimmte Zeitraum eine Ausgleichsladespannung und eine Ausgleichsladezeitspanne sind, die erforderlich sind, um alle Zellen der Batterie gleichmäßig und vollständig zu laden, und wenn die diskrete Größe anzeigt, dass der aktuelle Ladezustand oberhalb des kalibrierten Schwellenwertes liegt, in Abhängigkeit von einem aktuellen Energieumwandlungswirkungsgrad eines Antriebsstrangs, der als eine weitere diskrete Größe (LowEffFlag) erfasst wird, unterschiedliche von der Batterietemperatur abhängige Spannungseinstellungspunkte (Setpoint0, Setpoint1, ...) einer Lichtmaschine im Fahrzeug einzustellen (S2-S6 in Fig. 8), **dadurch gekennzeichnet, dass** die Mittel dazu ausgebildet sind, die diskrete Größe (LowSOCFlag), welche anzeigt, ob der aktuelle Ladezustand unterhalb oder oberhalb des kalibrierten Schwellenwertes (LowSOCThresh) liegt, mittels eines Algorithmus für diskrete Erkennung eines niedrigen Ladezustands zu erzeugen, welcher einen niedrigen Ladezustand durch Überwachung des Batteriestroms während eines Übergangs von einem relativ hohen zu einem relativ niedrigen Spannungseinstellungspunkt während einer vorbestimmten Zeitspanne erkennt, wobei der Batteriestrom nicht mittels eines Sensors direkt gemessen wird, sondern die Mittel dazu ausgebildet sind, den Batteriestrom mit Hilfe des Ausgangsstroms oder Tastverhältnisses der Lichtmaschine indirekt zu überwachen, und dass die von der Batterietemperatur abhängigen Spannungseinstellungspunkte (Setpoint0, Setpoint1, ...) jeweils eindeutige Funktionen der eingestellten Ausgangsspannung der Lichtmaschine von der Temperatur der Batterie sind.

## Claims

**1.** Method for the management of the electrical current supply in a motor vehicle having a combustion engine, wherein the charge state of a battery that can provide at least the current for the starter, ignition and lighting is detected as a discrete variable (LowSOCFlag) that indicates whether the prevailing charge state is below or above a calibrated threshold value (LowSOCThresh), wherein, if the discrete variable indicates (S1 in fig. 8) that the prevailing charge state is below the calibrated threshold value, the battery is charged using a relatively high voltage (*Setpoint1*) over a predetermined time period (S7-S13 in fig. 8), wherein the relatively high voltage and the predetermined time period are a compensating charging voltage and a compensating charging time period that are required in order to charge all cells of the battery uniformly and fully, and wherein,

if the discrete variable indicates that the prevailing charge state is above the calibrated threshold value, in dependence upon a prevailing energy conversion efficiency level of a drivetrain that is detected as a further discrete variable (LowEffFlag), different battery temperature-dependent voltage set points (*Setpoint0, Setpoint1*, ...) of an electric generator in the vehicle are set (S2-S6 in fig. 8),
**characterized in that**,

the discrete variable (LowSOCFlag) that indicates whether the prevailing charge state is below or above the calibrated threshold value (LowSOCThresh) is generated by means of an algorithm for the discrete identification of a low charge state, said algorithm identifying a low charge state by means of monitoring the battery current during a transition from a relatively high voltage set point to a relatively low voltage set point during a predetermined time period, wherein the battery current is not measured directly by means of a sensor, but is monitored indirectly with the aid of the output current or duty cycle of the electric generator, and **in that**

the battery temperature-dependent voltage set points (*Setpoint0, Setpoint1*, ...) are in each case single-valued functions of the set output voltage of the electric generator on the basis of the temperature of the battery.

**2.** Method according to Claim 1,
**characterized in that**,

the relatively high voltage (*Setpoint1*) for fully charging the battery is one of the multiple battery temperature-dependent voltage set points (*Setpoint0, Setpoint1,* ...) of the electric generator.

**3.** Method according to Claim 1 or 2,
**characterized in that**,

the battery temperature-dependent voltage set points comprise precisely one function (*Setpoint0*) for the operation where the energy conversion efficiency level of the drivetrain is low and also a function (*Setpoint1*) for the operation where the energy conversion efficiency level of the drivetrain is high.

**4.** Method according to Claim 3,
**characterized in that**,
the battery temperature-dependent voltage set points in addition comprise a function (*Setpoint2*) for the operation of the battery as an energy buffer for a regenerative braking operation, wherein the voltage set point is selected not only with reference to the further discrete variable (LowEffFlag) that characterizes the prevailing energy conversion efficiency level as being low or high but rather also with reference to a further discrete variable (DFSOFlag) that characterizes the prevailing energy conversion efficiency level as very high as a result of the deceleration of the vehicle without fuel supply.

**5.** Method according to any one of the preceding claims,
**characterized in that**,
the energy conversion efficiency level of the drivetrain is identified as being low or high or very high by means of monitoring input control signals and status reports of the drivetrain, in particular with reference to the accelerator pedal position (APP), the vehicle velocity (VehSpeed) and the engine rotational speed (EngSpeed).

**6.** Method according to any one of the preceding claims,
**characterized in that**,
the discrete variable (LowSOCFlag) that indicates whether the prevailing charge state is below or above the threshold value and where appropriate a battery charge time period that has since elapsed (EqChargeTime) are stored in a memory in which they are still retained in the case of a vehicle that has been switched off, and that the method continues with the discrete variable (LowSOCFlag) that is stored in this manner if the vehicle is restarted.

**7.** Device for the management of the electrical current supply in a motor vehicle having a combustion engine, wherein the device has means which are designed to detect the charge state of a battery that can provide at least the current for the starter, ignition and lighting as a discrete variable (LowSOCFlag) that indicates whether the prevailing charge state is below or above a calibrated threshold value (LowSOCThresh), wherein the means are also designed to carry out charging of the battery using a relatively high voltage (Setpoint1) for a predetermined time period if the discrete variable indicates (S1 in Fig. 8) that the prevailing charge state is below the calibrated threshold value (S7-S13 in Fig. 8), wherein the relatively high voltage and the predetermined time period are a compensating charging voltage and a compensating charging time period that are required in order to charge all cells of the battery uniformly and fully, and to set different battery temperature-dependent voltage set points (Setpoint0, Setpoint1, ...) of an electric generator in the vehicle if the discrete variable indicates that the prevailing charge state is above the calibrated threshold value, in dependence on a prevailing energy conversion efficiency level of a drivetrain that is detected as a further discrete variable (LowEffFlag) (S2-S6 in fig. 8),
**characterized in that**
the means are designed to generate the discrete variable (LowSOCFlag) that indicates whether the prevailing charge state is below or above the calibrated threshold value (LowSOCThresh) by means of an algorithm for discrete detection of a low charge state that detects a low charge state by monitoring the battery current during a transition from a relatively high voltage set point to a relatively low voltage set point during a predetermined time period, wherein the battery current is not measured directly by means of a sensor but the means are designed to monitor the battery current indirectly with the aid of the output current or duty cycle of the electric generator, and **in that** the battery temperature-dependent voltage set points (Setpoint0, Setpoint1, ...) are in each case single-valued functions of the set output voltage of the electric generator on the basis of the temperature of the battery.

**Revendications**

**1.** Procédé de gestion de l'alimentation en courant électrique dans un véhicule automobile comportant un moteur à combustion interne, dans lequel l'état de charge d'une batterie qui peut fournir le courant destiné au moins au démarreur, l'allumage et l'éclairage, est détecté en tant que grandeur discrète (LowSOCFlag), qui indique si l'état de charge actuel se situe en dessous ou au-dessus d'une valeur de seuil étalonnée (LowSOCThresh), dans lequel, lorsque la grandeur discrète indique (S1 sur la figure 8) que l'état de charge actuel se situe en dessous de la valeur de seuil étalonnée, une charge de la batterie est effectuée par utilisation d'une tension relativement élevée (*Setpoint1*) au cours d'une période de temps prédéterminée (S7-S13 sur la figure 8), dans lequel la tension relativement élevée et la période de temps prédéterminée sont une tension de charge et de compensation et un intervalle de temps de charge de compensation qui sont nécessaires pour charger toutes les cellules de la batterie de manière identique et complète, et dans lequel, lorsque la grandeur discrète indique que l'état de charge actuel se situe au-dessus de la valeur de seuil étalonnée, différents points de réglage de tension (*Setpoint0, Setpoint1, ...*), qui dépendent de la température de batterie, d'un alternateur sont réglés (S2-S6 sur la figure 8) dans le véhicule en fonction d'un rendement de conversion d'énergie actuel d'une chaîne cinématique, qui est détecté en tant qu'autre grandeur discrète (LowEffFlag),

**caractérisé en ce que** la grandeur discrète (LowSOCFlag) qui indique si l'état de charge actuel se situe en dessous ou au-dessus de la valeur de seuil étalonnée (LowSOCThresh) est générée au moyen d'un algorithme discret d'identification d'un état de faible charge, qui identifie un état de faible charge en surveillant le courant de batterie pendant une transition d'un point de réglage de tension relativement élevé à un point de réglage de tension relativement faible pendant un intervalle de temps prédéterminé, dans lequel le courant de batterie n'est pas directement mesuré au moyen d'un capteur mais est surveillé indirectement à l'aide du courant de sortie ou du rapport cyclique de l'alternateur, et **en ce que**

les points de réglage de tension (*Setpoint0, Setpoint1*, ...), qui dépendent de la température de la batterie, sont respectivement des fonctions univoques entre la tension de sortie réglée de l'alternateur et la température de la batterie.

2. Procédé selon la revendication 1,
**caractérisé en ce que** la tension relativement élevée (*Setpoint1*) permettant la charge complète de la batterie est l'un des multiples points de réglage de tension (*Setpoint0, Setpoint1,* ...) de l'alternateur, qui dépendent de la température de batterie.

3. Procédé selon la revendication 1 ou 2,
**caractérisé en ce que** les points de réglage de tension qui dépendent de la température de batterie comprennent une fonction (*Setpoint0*) permettant un fonctionnement à faible rendement de conversion d'énergie de la chaîne cinématique ainsi qu'une fonction (*Setpoint1*) permettant un fonctionnement à rendement de conversion d'énergie élevé de la chaîne cinématique.

4. Procédé selon la revendication 3,
**caractérisé en ce que** les points de réglage de tension qui dépendent de la température de batterie comprennent en outre une fonction (*Setpoint2*) permettant un fonctionnement de la batterie en tant que réserve d'énergie pour un freinage régénératif, dans lequel le choix du point de réglage de tension n'est pas effectué uniquement sur la base de l'autre grandeur discrète (LowEffFlag), qui caractérise le rendement de conversion d'énergie actuel comme étant faible ou élevé, mais également sur la base d'encore une autre grandeur discrète (DFSOFlag), qui caractérise le rendement de conversion d'énergie actuel comme étant très élevé sans admission de carburant en raison du ralentissement du véhicule.

5. Procédé selon l'un quelconque des revendications précédentes,
**caractérisé en ce que** l'identification du rendement de conversion d'énergie de la chaîne cinématique comme étant faible ou élevé ou comme étant très élevé est effectuée en surveillant des signaux d'entrée de commande et des messages d'état de la chaîne cinématique, en particulier sur la base de la position de la pédale d'accélérateur (APP), de la vitesse du véhicule (VehSpeed) et de la vitesse de rotation du moteur (EngSpeed).

6. Procédé selon l'un quelconque des revendications précédentes,
**caractérisé en ce que** la grandeur discrète (LowSOCFlag) qui indique si l'état de charge actuel se situe en dessous ou au-dessus de la valeur de seuil ainsi que, le cas échéant, un temps de charge de batterie s'étant écoulé jusqu'alors (EqChargeTime) sont stockés dans une mémoire dans laquelle ils ne sont pas perdus lorsque le véhicule est stationné, et **en ce que** le procédé se poursuit en utilisant la grandeur discrète (LowSOCFlag) ainsi stockée lorsque le véhicule est redémarré.

7. Dispositif de gestion de l'alimentation en courant électrique dans un véhicule automobile comportant un moteur à combustion interne, dans lequel le dispositif comporte des moyens qui sont conçus pour détecter l'état de charge d'une batterie qui peut fournir le courant destiné au moins au démarreur, l'allumage et l'éclairage, en tant que grandeur discrète (LowSOCFlag), qui indique si l'état de charge actuel se situe en dessous ou au-dessus d'une valeur de seuil étalonnée (LowSOCThresh), dans lequel, les moyens sont en outre conçus pour effectuer (S7-S13 sur la figure 8) une charge de la batterie par utilisation d'une tension relativement élevée (Setpoint1) au cours d'une période de temps prédéterminée lorsque la grandeur discrète indique (S1 sur la figure 8) que l'état de charge actuel se situe en dessous de la valeur de seuil étalonnée, dans lequel la tension relativement élevée et la période de temps prédéterminée sont une tension de charge de compensation et un intervalle de temps de charge de compensation qui sont nécessaires pour charger toutes les cellules de la batterie de manière identique et complète, et lorsque la grandeur discrète indique que l'état de charge actuel se situe au-dessus de la valeur de seuil étalonnée, pour régler (S2-S6 sur la figure 8) différents points de réglage de tension (*Setpoint0, Setpoint1,* ...), qui dépendent de la température de batterie, d'un alternateur dans le véhicule en fonction d'un rendement de conversion d'énergie d'une chaîne cinématique, qui est détecté en tant qu'autre grandeur discrète (LowEffFlag),

**caractérisé en ce que** les moyens sont conçus pour générer la valeur discrète (LowSOCFlag) qui indique si l'état de charge actuel se situe en dessous ou au-dessus de la valeur de seuil étalonnée (LowSOCThresh), au moyen d'un algorithme discret d'identification d'un état de faible charge, qui identifie un état de faible charge en surveillant le courant de batterie pendant une transition d'un point de réglage de tension relativement élevé à un point de réglage de tension relativement faible pendant un intervalle de temps prédéterminé, dans lequel le courant de batterie n'est pas directement mesuré au moyen d'un capteur mais les moyens sont conçus pour surveiller indirectement le courant de batterie à l'aide du courant de sortie ou du rapport cyclique de l'alternateur, et **en ce que** les points de réglage de tension (*Setpoint0, Setpoint1,* ...), qui dépendent de la température de batterie, sont respectivement des fonctions univoques entre la tension de sortie réglée de l'alternateur et la température de batterie.

## Fig. 1

Antriebsstrang-Daten

Elektrische Daten

Strategie für Energieum-wandlungs-wirkungsgrad — 1

Strategie für elektrische Robustheit — 2

3

Einstellungspunkt der Lichtmaschine

## Fig. 2

Spannungsein-stellungspunkt

Setpoint2

Setpoint1

Setpoint0

Temperatur

## Fig. 3

Verbrennungsmotor gestartet

S3

S1

S2

Setpoint1

Nein ← LowEffFlag ? → Ja

Setpoint0

## Fig. 4

Verbrennungsmotor gestartet

S4

LowEffFlag ? — Ja → Setpoint0 — S5

Nein

S6

DFSOFlag ? — Ja → Setpoint2 — S7

Nein

S3

S1

S2

Setpoint1 ← Nein — LowEffFlag ? — Ja → Setpoint0

# Fig. 5

Verbrennungsmotor gestartet

Setze
LowEffFlag = 1

S2

S1

VehSpeed > 0 ?    Nein

Ja

Setze
TimeStamp = t    S3

S4

APP > 0 ?    Nein    Ja

S5

S9    S11

VehSpeed > 0
UND EngSpeed >
DFSOSpThresh
?

S6    Nein

t – TimeStamp >
LaunchTimeThresh ODER
APP < WOTThresh
?    Nein

Setze
LowEffFlag = 1

Nein

VehSpeed > 0 ?

Ja

Ja

Setze
LowEffFlag = 1
DFDOFlag = 0

Setze
LowEffFlag = 0
DFDOFlag = 1

S8

Setze
LowEffFlag = 0    S10

S7

# Fig. 6a

Batterieklemmenspannung

$U_Z$

$\longleftarrow$ Überwachungszeitspanne $\longrightarrow$

$U_{Thresh}$

t

# Fig. 6b

Batteriestrom

Laden

0

Vollständige Entladung:
SOC>SOC $_{Thresh}$

Entladen

t

# Fig. 6c

Batteriestrom

Laden

0

Unvollständige Entladung:
SOC<SOC $_{Thresh}$

Entladen

t

# Fig. 7

# Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005046342 A1
- DE 102004023621 A1
- US 6646419 B1
- US 8159188 B2
- US 8638070 B2

**In der Beschreibung aufgeführte Nicht-Patentliteratur**

- **BALLICHI ; BENVENUTI ; DI BENEDETTO ; PINELLO ; SANGIOVANNI-VINCENTELLI.** Automotive Engine Controls and Hybrid Systems: Challenges and Opportunities. *Proceedings of the IEEE,* Juli 2000